# EUROPEAN PATENT APPLICATION

(11) **EP 0 878 844 A2**
(43) Date of publication of application: **18.11.1998**
(21) Application number: 98302203.9
(22) Date of filing: 24.03.1998
(51) Int. Cl.: H01L 23/14

(54) **High frequency apparatus including a low loss substrate**

(30) Priority: 03.04.1997 US 832550
(71) Applicant: LUCENT TECHNOLOGIES INC., Murray Hill, New Jersey 07974-0636 (US)
(72) Inventor: Lau, Maureen Yee, Warren, New Jersey 07059 (US); Rai, King Lien, Berkelley Heights, New Jersey 07922 (US); Lin, Jenshan, Pine Brook, New Jersey 07058 (US)
(74) Representative: Buckley, Christopher Simon Thirsk

(57) **Abstract**

Single crystal silicon is a conventionally used substrate material for multi-chip modules, especially for high frequency use. We have found that substitution of polycrystalline silicon of resistivity greater than 2000 ohm · cm for the conventional single crystal silicon can result in significant performance improvement as well as in cost reduction. For instance, such substitution can result in significant improvement of the quality factor of an inductor disposed on the substrate, or in transmission lines of lower loss.

## Description

### Field of the Invention

This invention pertains to high frequency electronic apparatus, exemplarily a RF, UHF or micro-wave transceiver, that comprises a low loss substrate. Exemplarily the apparatus also comprises a transmission line and/or a planar inductor on the substrate.

### Background

Considerable effort is currently being expended on the development of high frequency electronic apparatus, e.g., hand-held telephones and other personal communication devices. Such devices, in order to be commercially acceptable, should have low power consumption for extended battery life, and should have low cost.

High frequency apparatus of the type of concern herein generally requires, in addition to active elements such as transistors, passive elements such as resistors, capacitors and inductors, as well as transmission lines. Whereas resistors and capacitors are readily compatible with conventional IC technology, prior art inductors generally are not. Furthermore, prior art inductors generally require substantial "real estate" on a chip, and typically have relatively low quality factor (Q).

Conventionally, inductors for use in or with integrated circuits are formed on a resistive substrate, exemplarily a single crystal silicon (Si) substrate, a glass substrate or a co-fired ceramic substrate. All of these have shortcomings, however.

Single crystal Si substrates have high thermal conductivity, which facilitates heat removal. Si single crystal substrates also facilitate flip-chip, fine line thin film interconnections, are readily compatible with integrated resistors and capacitors, and to date can provide maximum miniaturization to provide the best electrical environment. Inductors on single crystal Si substrates can be accurately modeled and simulated, thereby facilitating circuit design and development.

However, the resistivity of commercially available single crystal Si substrates typically is only about 2000 ohms·cm or less, with the cost of higher resistivity single crystal Si wafers, if at all available, likely increasing steeply with increasing resistivity. For prior art inductors on single crystal Si, typical obtainable values of Q are 10-20, depending on the value of inductance and the geometry of the inductor.

Efforts are being undertaken to obtain higher Q inductors on single crystal Si substrates. However, the proposed structures are quite complicated, and thus are likely to be expensive and difficult to manufacture. See, for instance, the article "Multilevel inductors boost wireless design", Electronic Engineering Times, October 21, 1996, p. 39, which reports formation of a 2-level inductor on a single crystal Si substrate, the inductor having 1.5 nH inductance and a Q of 24. Use of float-zone single crystal Si resulted in increase of the Q to 30, and use of sapphire produced a Q of 40. Multichip modules using silicon substrates are discussed, for instance, in "Multichip Module Technologies and Alternatives", D. A. Doane et al., editors, Van Nostrand Reinhold, New York 1993, especially chapter 16.

Glass substrates are good insulators and therefore can yield high Q inductors. However, glass substrates are poor heat conductors, and also have other disadvantages. Due to the relatively fragile nature of glass and the thermal expansion mismatch between the glass substrate and other materials (e.g., Si), cracks and breaks in the substrate are quite frequent, resulting in low yield and potentially, low reliability. For an example of glass-based technology, see, for instance, D-W. Wu, 1996 IEEE MTT-S Digest, paper WE 3D-3.

Co-fired ceramic substrates have high resistivity and thus also can yield high Q inductors. However, co-fired ceramic substrates typically are also relatively poor heat conductors, and require the use of screen printing to define the conductor structure, and thus inherently have relatively large feature size. Thus, typically several layers of ceramic are required in order to achieve the same level of integration as in the case of thin film technology. Such substrates typically are relatively expensive, and it is typically difficult to model circuits that involve such substrates.

A low cost substrate that substantially retains the many advantages of single crystal Si and has resistivity higher than that of conventional single crystal Si would clearly be highly desirable. This application discloses such a substrate, and circuitry formed on the substrate.

It should be pointed out that the intrinsic resistivity of Si at 300K is reported to be 2.5 x 10⁵ ohm · cm. See, for instance, B. G. Streetman, "Solid State Electronic Devices", 2nd edition, 1980, p. 443. However, silicon of such high resistivity is not commercially available, and would have unacceptably high cost.

### Summary of the Invention

The invention is defined by the claims. In a broad aspect the invention is embodied in an article (e.g., a high frequency transceiver, a wireless telephone handset, a "personal communicator", or a communication system that comprises such transceivers, handsets or personal communicators) that comprises a low cost, relatively low loss (high resistivity) substrate, exemplarily with a transmission line and/or an inductive circuit element disposed on the substrate.

More specifically, the article comprises a silicon substrate. In a preferred embodiment an inductive circuit element (e.g., a spiral coil) is disposed on the substrate such that a quality factor Q of the inductive circuit element is a function of the resistivity of the silicon body. Exemplarily the inductive circuit element (to be referred to as the "inductor") is disposed on the silicon substrate, with a dielectric layer (typically SiO₂) between the silicon substrate and the inductor. As those skilled in the art will know, the Q of the inductor is a function of the resistivity of the silicon body if the electromagnetic field of the inductor penetrates into the silicon body.

Significantly, the silicon body is a polycrystalline silicon body havingresistivity greater than about 2000 ohm · cm, desirably as much as 10⁴ ohm · cm or even more.

As a consequence of provision of the low cost, high resistivity polycrystalline silicon substrate, the high frequency apparatus can have improved performance (e.g., increased Q of an inductor and/or lower loss transmission lines), typically at reduced cost, as compared to analogous prior art apparatus that comprises a conventional single crystal Si substrate.

By "polycrystalline" silicon we mean herein silicon of grain size small enough to provide sufficient grain boundary scattering to give resistivity greater than 2000 ohm · cm. Exemplarily the average grain size is less than 10 µm.

### Brief Description of the Drawings

FIG. 1 schematically shows a co-planar waveguide transmission line on a polycrystalline substrate;
FIGs. 2-4 show exemplary measurement data;
FIGs. 5 and 6 depict an exemplary planar inductor on a polysilicon substrate;
FIG. 7 shows exemplary data on quality factor vs. frequency; and
FIG. 8 schematically depicts a relevant portion of apparatus according to the invention.

### Detailed Description of Exemplary Embodiments

Those skilled in the art will appreciate that high resistivity polycrystalline Si is available at relatively low cost, since such material is an intermediate product in the manufacture of single crystal Si for electronic device manufacture. Exemplarily, polycrystalline Si suitable for practice of the invention can be obtained from Advanced Silicon Materials, Inc., of Moses Lake, Washington.

The polycrystalline material typically is in the form of aboule, similar to conventional single crystal material, with the cost of a boule of polycrystalline material exemplarily being less than 50% of the cost of a similar boule for conventional single crystal silicon. The cost of sectioning into wafers and polishing of the wafers can be expected to be substantially the same for both types of silicon, at least after the demand for polycrystalline wafers has increased due to widespread practice of the instant invention. It should, however, be noted that boules of polycrystalline silicon frequently are in a state of stress, and that it is typically advantageous to relieve the stresses by an appropriate heat treatment (e.g., 12 hours at 1000°C) before sectioning of the boules. Such a treatment will typically add little to the cost of polycrystalline Si wafers, and is not expected to substantially affect the cost advantage of polycrystalline Si wafers over conventional single crystal Si wafers.

Use of a polycrystalline Si substrate not only offers an economic advantage over conventional single crystal Si substrates but typically also has technological advantages, e.g., attainment of inductors having higher Q, and lower loss transmission lines.

Polycrystalline Si substrates will typically find use in high frequency, (e.g., RF, UHF and microwave frequency, typically ≥ 800 MHz) applications. It is thus important that the material exhibits high resistivity at high frequencies. This was verified as follows.

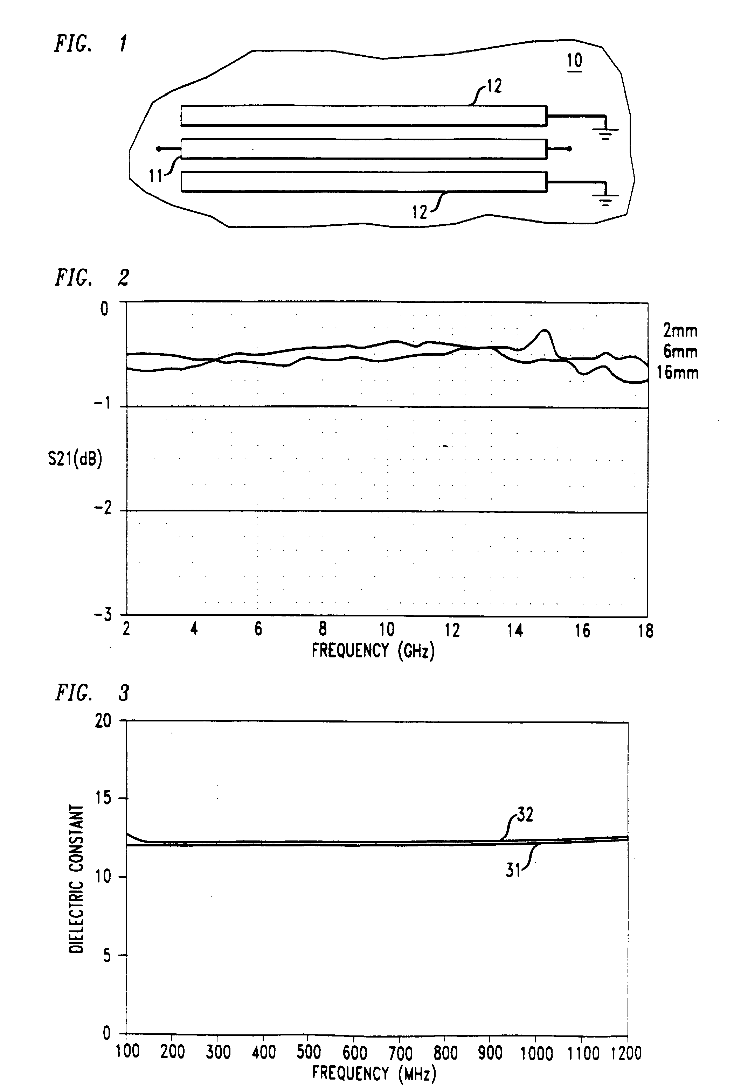

Co-planar waveguide (CPW) transmission lines were fabricated by conventional means on a polycrystalline Si substrate, substantially as shown in FIG. 1 in top view. The substrate was commercially available polycrystalline silicon (675 µm thick). The transmission lines 10 were 2 mm, 6 mm and 16 mm long, with central conductor 11 being 50 µm wide, with spacing between central conductor and ground electrodes 12 being 39 µm. Ground electrodes and central conductor were 3 µm thick Al.

The transmission lines were characterized by measuring the scattering parameters (S-matrix) over the frequency range 2 GHz - 18 GHz. Such measurements are conventional and can be carried out with commercially available apparatus, e.g., a Hewlett-Packard 8510 Network Analyzer.

The S₂₁ matrix element includes the transmission line loss and the mismatch loss. The latter can be eliminated from the measured S₂₁ by comparing transmission lines of different lengths, yielding the value of the transmission line loss of a given line. As those skilled in the art will know, the transmission line loss indicates how well the transmission line performs at high frequency. The smaller the loss, the better the performance.

The measured insertion losses at 18 GHz were 0.6 dB, 0.7 dB and 1.0 dB, respectively for the 2 mm, 6 mm and 16 mm long lines, yielding values of 0.25 dB/cm, 0.3 dB/cm and 0.29 dB/cm. From these and other results we concluded that the polycrystalline Si substrate had excellent electrical performance, comparable to that of a semi-insulating GaAs substrate, but with much better heat dissipation performance and mechanical strength than GaAs.

FIG. 2 shows exemplary results of S₂₁ vs. frequency for the above-described CPW transmission lines on polycrystalline Si. . The insertion loss is relatively low and substantially frequency-independent over the range 2-18 GHz.

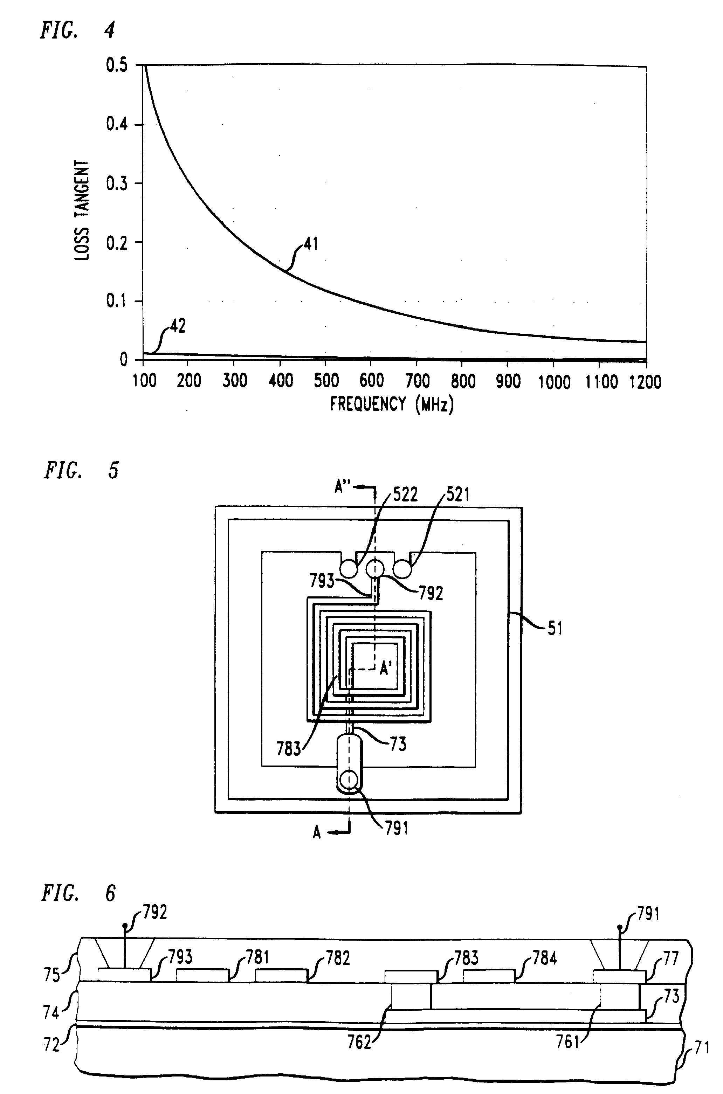

The measurements of FIGs. 3 and 4 were made by a conventional technique, using a Hewlett-Packard 4291A Impedance Analyzer.

Important parameters of a material for high frequency applications are the dielectric constant and the loss tangent. FIG. 3 shows the dielectric constant as a function of frequency for 2 kΩ ^{.} cm single crystal Si (curve 31), and polycrystalline Si (curve 32). As can be seen, the two materials have substantially identical dielectric constant.

FIG. 4 shows loss tangent as a function of frequency, for 2kΩ ^{.} cm single crystal Si (curve 41) and polycrystalline Si (curve 42). As is evident from FIG. 4, the polysilicon (∼10kΩ ^{.} cm) has much lower loss tangent than the 2kΩ ^{.} cm single crystal Si. Indeed, the loss tangent of the former was substantially the same as that of glass.

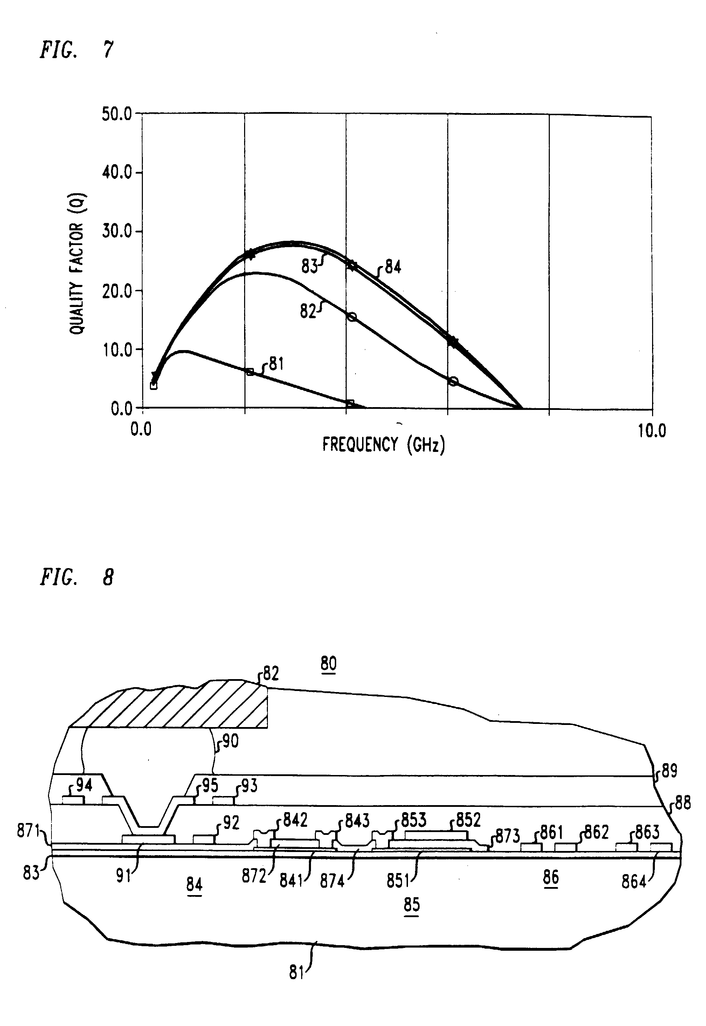

FIG. 5 shows an exemplary (500 µm x 500 µm) spiral inductor on a polycrystalline substrate in top view, and FIG. 6 schematically depicts an inductor, similar to that of FIG. 4, in cross section, substantially along section line A-A'-A" of FIG. 5. For the sake of clarity, FIG. 6 shows only two inductor turns.

In FIG. 6, numeral 71 refers to the polycrystalline Si substrate (675 µm thick, about 10⁴ ohm · cm resistivity), 72 to a 1 µm SiO₂ layer, and 73 to the Al conductor that connects via 762 and 761. Numerals 74 and 75 refer each to a 5 µm polyimide layer, and numerals 781-784 refer to inductor lines (exemplarily Al of 15 µm x 3 µm cross section, with 15 µm spacing between adjacent lines). Numeral 77 refers to the ground line contact, and 79 refers to the second inductor terminal. Polyimide layer 74 is patterned to provide via holes, and layer 75 is patterned to facilitate electrical contact to the inductor, as indicated schematically by contacts 791 and 792. Numeral 793 refers to the short conductor line that connects the inductor to terminal 792.

Corresponding features in FIG. 5 are designated by the same numerals as in FIG. 6. Numeral 51 refers to the ground ring, and numerals 521 and 522 refer to probe contacts.

FIG. 7 shows computed curves of quality factor Q vs. frequency, for inductors of geometry as shown in FIGs. 5 and 6, except that the inductor line thickness was assumed to be 6 µm, in order to reduce metal loss. Curves 81-84 of FIG. 7 pertain to inductors on substrates of resistivity 20 ohm · cm, 2000 ohm · cm, 10,000 ohm · cm and 20,000 ohm · cm, respectively. As can be seen, a large improvement in Q results from going from a 20 ohm · cm substrate to a 2000 ohm · cm substrate, and a significant improvement results for going from the latter to a 10,000 ohm · cm substrate. On the other hand, for the geometry considered, very little is gained by going from 10,000 ohm · cm to 20,000 ohm · cm, due to metal loss.

Indeed, because of dominating metal loss, there is frequently little advantage in using substrate material with resistivity greater than about 10⁴ ohm · cm. As will be recognized by those skilled in the art, the details of the above conclusions depend inter alia on the inductor geometry. However, it will be generally true that significant technological benefits result from going from a 2000 ohm · cm Si substrate to a 10,000 ohm · cm Si substrate. As discussed above, this can be done, not only without added expense but typically at a cost saving, by going from a conventional single crystal Si substrate to a polycrystalline Si substrate.

FIG. 8 schematically depicts a relevant portion of exemplary high frequency apparatus 80 according to the invention, wherein numeral 81 refers to a polycrystalline Si substrate according to the invention. Numeral 82 refers to a conventional IC chip, solder-bonded to the substrate, and numeral 83 refers to a SiO₂ layer thereon. Numerals 84-86 respectively refer to a resistor, capacitor and inductor, disposed on the SiO₂ layer. Numeral 841 refers to moderately conductive material (e.g.,TaSi) connecting Al vias 842 and 843. Numerals 871-874 refer to portions of a patterned dielectric layer (exemplarily Si₃N₄), with portion 873 serving as the dielectric layer of capacitor 85. Numeral 851 refers to moderately conductive material (e.g., TaSi) that forms one plate of capacitor 85, numeral 852 refers to the other plate (typically Al) of the capacitor, and numeral 853 refers to a Al via that provides contact to capacitor plate 851. Numerals 861-864 refer to windings of inductor 86. Means for contacting the inductor windings are conventional and are not shown. Numerals 88 and 89 refer to polyimide layers, numeral 90 refers to a solder ball that electrically connects chip 82 to conductor 91 on the substrate. Conductors 92-94 are disposed on two different metallization layers and are conventional, as is via metallization 95.

## Claims

1. An article comprising electronic circuitry for operation at and above radio frequency and comprising a silicon substrate (71) that supports one or more circuit components,
CHARACTERIZED IN THAT
said silicon substrate is a polycrystalline silicon substrate having resistivity greater than about 2000 ohm · cm.

2. Apparatus according to claim 1, wherein said circuit components comprise an inductive element.

3. Apparatus according to claim 2, wherein said inductive element is a planar inductor disposed on an insulator layer on said polycrystalline silicon substrate.

4. Apparatus according to claim 1, wherein said circuit components comprise a transmission line.

5. Apparatus according to claim 1, wherein said polycrystalline silicon substrate has an average crystallite size of 10 µm or less.

6. Apparatus according to claim 1, wherein said polycrystalline silicon substrate has resistivity of about 10⁴ ohm · cm.

7. Apparatus according to claim 3, wherein the planar inductor has a quality factor Q > 20 at a frequency of 2 GHz.
